(19) Europäisches Patentamt
European Patent Office
Office européen des brevets

(11) Veröffentlichungsnummer : **0 264 543 B1**

(12) **EUROPÄISCHE PATENTSCHRIFT**

(45) Veröffentlichungstag der Patentschrift : **03.04.91 Patentblatt 91/14**

(51) Int. Cl.$^5$ : **C07C 255/52**, C07C 255/57, // C09B3/18, H01L31/02

(21) Anmeldenummer : **87108848.0**

(22) Anmeldetag : **20.12.84**

# (54) Perylenverbindungen.

(30) Priorität : **13.01.84 DE 3400991**

(43) Veröffentlichungstag der Anmeldung : **27.04.88 Patentblatt 88/17**

(45) Bekanntmachung des Hinweises auf die Patenterteilung : **03.04.91 Patentblatt 91/14**

(84) Benannte Vertragsstaaten : **CH DE FR GB IT LI**

(56) Entgegenhaltungen : **DE-A- 2 512 516**

(61) Veröffentlichungsnummer der früheren Anmeldung nach Art. 76 EPü : **0156997**

(73) Patentinhaber : **BASF Aktiengesellschaft
Carl-Bosch-Strasse 38
W-6700 Ludwigshafen (DE)**

(72) Erfinder : **Iden, Ruediger, Dr. Chem.
Ruhhecke 25a
W-6720 Speyer (DE)**
Erfinder : **Seybold, Guenther, Dr. Chem.
Friedrich-Ebert-Strasse 14
W-6708 Neuhofen (DE)**

EP 0 264 543 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Aus den DE-OS 30 01 857, 26 20 115 und 25 54 226 sind Vorrichtungen bekannt, in denen sichtbares Licht in einer Kunststoffplatte durch eingelagerte Fluoreszenzzentren auf eine kleine Fläche konzentriert werden kann.

In der EP-A-0033079 wird die flächenmäßige Konzentration von Licht mittels fluoreszierender Verbindungen beschrieben, die der Formel

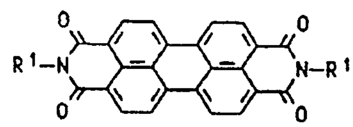

entsprechen, worin beide $R^1$ gleiche oder verschiedene keine wasserlöslich machende Gruppen enthaltende orthosubstituierte aromatische oder heterocyclische Reste sind. Als aromatische und heterocyclische Reste kommen für $R^1$ orthosubstituiertes Phenyl, 1-Naphthyl-1, 5,6,7,8-Tetrahydronaphthyl-1, Chinolinyl-1, Pyrazolyl-5 und Benzisothiazolyl-3, die gegebenenfalls noch durch 1 oder 2 Reste substituiert sein können, in Betracht.

Die gemäß der EP-A-0033079 als Fluoreszenzzentren verwendete Verbindungen sind im Gegensatz zu den nicht in ortho-Stellung substituierten N,N-Bisarylimiden der Perylen-3,4,9,10-tetracarbonsäure in organischen Lösungsmitteln und in Kunststoffen wesentlich besser löslich (S. 10, Z. 4/13). Die bei dem Verfahren gemäß der EP-A 0033079 angewendeten Farbstoffe geben sehr lichtechte Färbungen.

Die in diesen Vorrichtungen als Fluroeszenzzentren benötigten Verbindungen müssen insbesondere im Falle der Umwandlung von Lichtenergie in elektrische oder thermische Energie eine hohe Lichtechtheit aufweisen, damit die Vorrichtungen eine für die Anwendung ausreichende Lebensdauer aufweisen. D.h., die als Fluoreszenzzentren verwendeten Verbindungen müssen in den verwendeten Kunststoffen eine hohe Photostabilität aufweisen.

Es ist bekannt, daß Derivate der Perylen-3,9-dicarbonsäure als Fluoreszenzzentren mit ausreichender Quantenausbeute zur Konzentrierung von Licht verwendet werden können, jedoch haben diese Verbindungen den Nachteil, daß diese eine ungenügende Photostabilität, z.B. in Polymethylmethacrylat aufweisen.

Aufgabe der vorliegenden Erfindung war es, für die bekannten Vorrichtungen zur Lichtkonzentrierung als Fluoreszenzzentren geeignete Verbindungen bereitzustellen, die bei gleichzeitig hoher Lichtechtheit in dem verwendeten Medium eine hohe Fluoreszenzquantenausbeute aufweisen und die auf das Medium keine nachteilige Wirkung ausüben.

Die Erfindung betrifft Perylenverbindungen der Formel (IV)

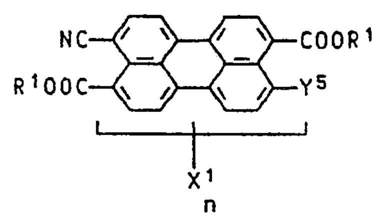

(IV),

in der $X^1$ für Chlor oder Brom, n für 0, 1 oder 2, $Y^5$ für Cyan oder Halogen und $R^1$ für Wasserstoff, lineares oder verzweigtes $C_1$-bis $C_{18}$-Alkyl, für $C_7$-bis $C_{18}$-Cycloalkyl oder für durch $C_5$-bis $C_{18}$-Cycloalkyl substituiertes $C_1$- oder $C_2$-Alkyl stehen.

Mit den erfindungsgemäßen Perylenverbindungen (IV) erhält man in den Kunststoffen, die zur Herstellung der für die Lichtkonzentration benötigten Platten oder Folien verwendet werden, sehr lichtechte Färbungen, die das eingestrahlte Licht in hoher Ausbeute in Fluoreszenzlicht umwandeln. Die Wellenlänge des Fluoreszenzlichtes liegt zwischen 450 und 550 nm.

Von den Perylenverbindungen (IV) sind solche der Formel (V) besonders bevorzugt :

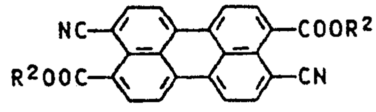

(V),

in der $R^2$ für lineares oder verzweigtes $C_4$-bis $C_{18}$-Alkyl, vorzugsweise für n-Butyl, Neopentyl, i-Butyl, 2-Ethylhexyl, n-Octyl, n-Tridecyl oder n-Octadecyl stehen.

Die Herstellung der neuen Perylenverbindungen (IV) erfolgt nach an sich bekannten Verfahren.

Zur Anwendung werden die Verbindungen (IV) in für die Anwendung geeigneten Kunststoffen (Medien) eingearbeitet. Hierzu wird der Kunststoff als Granulat mit der benötigten Menge an (IV) gepudert und die Granulate dann zu Flächengebilden extrudiert. Mit (IV) gefärbte Flächengebilde können auch durch Eintauchen der Gebilde in eine Lösung von (IV) erhalten werden, wobei (IV) in den Kunststoff diffundiert. Eine weitere Möglichkeit besteht darin, die (IV) enthaltenden Monomere oder Monomerengemische zum Kunststoff zu polymerisieren. Man kann die Flächengebilde auch durch Gießen aus einer Lösung, die den Kunststoff und die Verbindung (IV) gelöst enthält, herstellen.

Für die Verwendung zur Konzentration von Licht, z.B. für Solarzellen kommen als Kunststoffe (Medium) z.B. Polymethylmethacrylat, Polymethylacrylat, Polystyrol, Polydiethylenglykol-diallylbiscarbonat, ferner auch für diesen Zweck geeignete Polyamide und Polycarbonate in Betracht.

Die Erfindung soll durch die folgenden Beispiele weiter erläutert werden.

Die im folgenden angegebenen Teile und Prozentangaben beziehen sich auf das Gewicht.

PMMA = Polymethylmethacrylat

Sulfolan = Tetrahydrothiophen-1,1-dioxid

Beispiel 1

a) In 100 Teile Sulfolan wurden 12 Teile 4,10-Dibrom-perylen-3,9-dicarbonsäureisobutylester und 9 Teile Kupfercyanid 25 Stunden bei 130 bis 140°C gerührt.

Das Umsetzungsprodukt wurde durch Austragen auf 400 Teile Wasser gefällt, abgesaugt, das Filtergut in verdünntem Ammoniak digeriert, abgesaugt, mit Wassr neutral gewaschen und getrocknet. Nach der Extraktion mit Toluol wurden 9 Teile Rohfarbstoff mit einem Bromgehalt von 1,2% isoliert.

Der Farbstoff wurde durch Mitteldruck-Säulenchromatographie an Kieselgel mit Trichlorethan/Ethanol als Eluens gereinigt. Ausbeute : 6 Teile 4,10-Dicyanperylen-3,9-dicarbonsäureisobutylester. Schmp. 228-230°C.

Fluoreszenzquantenausbeute in Chloroform : 91%.

b) Dieser Farbstoff wurde in PMMA (Konzentration : 0,05%) eingearbeitet. Das Absorptionsmaximum liegt bei 474 nm und das Emissionsmaximum bei 508 nm.

Nach 168-stündiger Belichtung beträgt der Unterschied in der Extinktion bei $\lambda_{max}$ = 4%.

Beispiel 2 bis 7

Es wurde entsprechend den Angaben in Beispiel 1 verfahren, jedoch wurde anstelle des 4,10-Dibromperylen-3,9-dicarbonsäureisobutylesters die äquivalente Menge der in der Tabelle angegebenen Ester verwendet.

Die erhaltenen Rohester wurden durch Säulenchromatographie gereinigt.

Das Absorptions- und Emissionsmaximum der Ester wurde an 0,05%igen Färbungen in PMMA bestimmt.

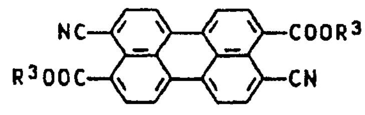

| Beispiel | $R^3$ | Absorptions-Emissions-maximum (PMMA) [nm] | [nm] |
|---|---|---|---|
| 2 | $-CH_2-CH_2-CH_2-CH_3$ | 474 | 509 |
| 3 | $-CH_2-C(CH_3)_2-CH_3$ | 473 | 508 |
| 4 | $-CH_2-CH(C_2H_5)-C_4H_9(n)$ | 474 | 509 |
| 5 | $-C_8H_{17}(n)$ | 474 | 508 |
| 6 | $-C_{13}H_{27}(n)$ | 473 | 508 |
| 7 | $-C_{18}H_{37}(n)$ | 474 | 507 |

## Ansprüche

1. Perylenverbindungen der Formel

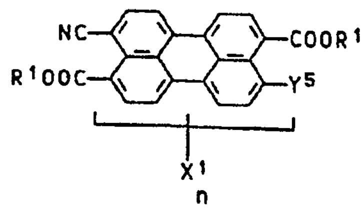

in der

$Y^5$ für Halogen oder Cyan

$R^1$ für Wasserstoff, lineares oder verzweigtes C1-bis $C_{18}$-Alkyl, durch $C_5$-bis $C_{18}$-Cycloalkyl substituiertes $C_1$- oder $C_2$-Alkyl oder für $C_7$-bis $C_{18}$-Cycloalkyl und wobei die Cycloalkylreste 1 bis 4 Ringe enthalten können,

$X^1$ für Chlor oder Brom und

n für 0, 1 oder 2 stehen.

2. Perylenverbindungen gemäß Anspruch 1, dadurch gekennzeichnet, daß $Y^5$ für Chlor, Brom oder Cyan steht.

3. Perylenverbindungen gemäß Anspruch 1, gekennzeichnet durch die Formel

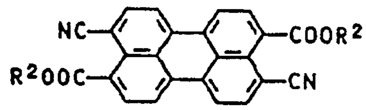

in der $R^2$ für lineares oder verzweigtes $C_4$-bis $C_{18}$-Alkyl steht.

4. Perylenverbindungen gemäß Anspruch 3, dadurch gekennzeichnet, daß in der Formel $R^2$ für n-Butyl, i-Butyl, Neopentyl, 2-Ethylhexyl, n-Octyl, n-Tridecyl oder Octadecyl steht.

5. Perylenverbindungen gemäß Anspruch 1 oder 2, dadurch gekennzeichnet, daß $R^1$ für n-Butyl, i-Butyl, Neopentyl, 2-Ethylhexyl, n-Octyl, n-Tridecyl oder Octadecyl steht.

## Claims

1. A perylene compound of the formula

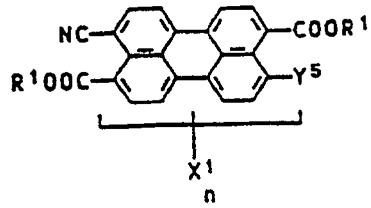

where
$Y^5$ is halogen or cyano,
$R^1$ is hydrogen, linear or branched $C_1$-$C_{18}$-alkyl, $C_5$-$C_{18}$-cycloalkyl-substituted $C_1$- or $C_2$-alkyl, or $C_7$-$C_{18}$-cycloalkyl, cycloalkyl comprising from 1 to 4 rings,
$X^1$ is chlorine or bromine, and
n is 0, 1 or 2.

2. A perylene compound as claimed in claim 1, wherein $Y^5$ is chlorine, bromine or cyano.

3. A perylene compound as claimed in claim 1, of the formula

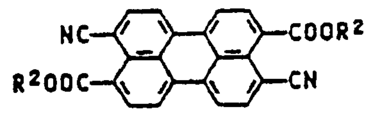

where $R^2$ is linear or branched $C_4$-$C_{18}$-alkyl.

4. A perylene compound as claimed in claim 3, wherein $R^2$ is n-butyl, isobutyl, neopentyl, 2-ethylhexyl, n-octyl, n-tridecyl or octadecyl.

5. A perylene compound as claimed in claim 1 or 2, wherein $R^1$ is n-butyl, isobutyl, neopentyl, 2-ethylhexyl, n-octyl, n-tridecyl or octadecyl.

## Revendications

1. Dérivés de pérylène de formule

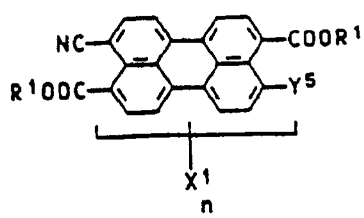

dans laquelle
$Y^5$ est mis pour un atome d'halogène ou un groupement cyano,
$R^1$ est mis pour un atome d'hydrogène, un groupement alkyle en $C_1$-$C_{18}$ linéaire ou ramifié, un groupement alkyle en $C_1$-$C_2$ substitué par un reste cycloalkyle en $C_5$-$C_{18}$, ou un groupement cycloalkyle en $C_7$-$C_{18}$, les restes cycloalkyle pouvant contenir de 1 à 4 cycles,
$X^1$ est mis pour un atome de chlore ou de brome, et
n est mis pour 0, 1 ou 2.

2. Dérivés de pérylène selon la revendication 1, caractérisés en ce que $Y^5$ est mis pour un atome de chlore ou de brome ou pour un groupement cyano.

3. Dérivés de pérylène selon la revendication 1, caractérisés par la formule

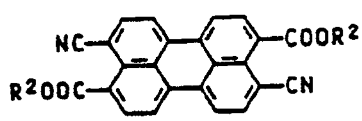

dans laquelle $R^2$ est mis pour un groupement alkyle en $C_4$-$C_{18}$ linéaire ou ramifié.

4. Dérivés de pérylène selon la revendication 3, caractérisés en ce que dans la formule $R^2$ est mis pour un groupement n-butyle, i-butyle, néopentyle, 2-éthylhexyle, n-octyle, n-tridécyle ou octadécyle.

5. Dérivés de pérylène selon la revendication 1 ou 2, caractérisés en ce que $R^1$ est mis pour un groupement n-butyle, i-butyle, néopentyle, 2-éthylhexyle, n-octyle, n-tridécyle ou octadécyle.